# EUROPÄISCHE PATENTSCHRIFT

(11) **EP 3 825 105 B1**
(45) Veröffentlichungstag und Bekanntmachung des Hinweises auf die Patenterteilung: **22.10.2025**
(21) Anmeldenummer: 21151984.8
(22) Anmeldetag: 21.12.2016
(51) Int. Cl.: B29C 67/00, B33Y 50/02

(54) **MESSVERFAHREN ZUR ERZEUGUNG EINES DREIDIMENSIONALEN KÖRPERS**
MEASURING METHOD FOR CREATING A THREE-DIMENSIONAL BODY
PROCÉDÉ DE MESURE POUR LA PRODUCTION D'UN CORPS TRIDIMENSIONNEL

(30) Priorität: 22.12.2015 AT 510972015
(43) Veröffentlichungstag der Anmeldung: 26.05.2021
(62) Teilanmeldung aus: 16828913.0
(73) Patentinhaber: Stadlmann, Klaus, 1020 Wien (AT)
(72) Erfinder: Stadlmann, Klaus, 1020 Wien (AT)
(74) Vertreter: Aldridge, Henry Alexander

(56) Entgegenhaltungen:
- EP-B1- 2 604 417
- WO-A1-2009/025845

## Beschreibung

Die Erfindung betrifft allgemein eine Stereolithographie-Vorrichtung zur Herstellung eines dreidimensionalen Körpers durch schichtweises Aushärten eines fotosensitiven Materials sowie ein Verfahren zur Beschleunigung des Herstellungsprozesses durch eine orts- und zeitaufgelöste Messmethode; die Vorrichtung umfasst dabei:
- eine Referenzschicht;
- eine Strahlungsquelle zum Erzeugen der für die Aushärtung notwendigen spezifischen Strahlung;
- einen Sensor; und
- zumindest eine passive Strahlungsquelle zur Erzeugung einer Mess-Strahlung.

Mehr im Einzelnen bezieht sich die Erfindung auf ein Verfahren zur Erzeugung eines dreidimensionalen Körpers in einem stereolithographischen Prozess, wobei ein fotosensitives Material durch Strahlung ausgehärtet wird.

In Stereolithographie-Anlagen, vgl. z.B. EP 2 173 538 B1, wird eine fotosensitive Flüssigkeit durch Einwirken einer geeigneten Strahlung, z.B. UV-Strahlung, in eine Schicht eines dreidimensionalen Körpers umgewandelt. Die Erfindung befasst sich mit der Beschleunigung eines solchen stereolithographischen Prozesses durch ein optisches Messverfahren, das bei einer derartigen Anlage eingesetzt werden kann.

Unter Stereolithographie wird üblicherweise ein Prozess verstanden, der es erlaubt, einen dreidimensionalen Körper durch Aneinanderreihen von einzelnen Schichtformationen zu erzeugen. Dieses grundlegende Prinzip ist auch unter Begriffen wie Rapid Prototyping, 3D-Druck, Generative Fertigung usw. bekannt.

In stereolithographischen Prozessen werden neben steuerbaren Laserquellen auch Strahlungsquellen eingesetzt, welche die Schichtformation durch den Einsatz von digitalen Maskenbelichtungssystemen, sögenannten MEMS- oder DLP-Chips, oder Displays erzeugen. Der Vorteil bei pixelbasierten Belichtungssystemen liegt darin, dass die gesamte Schichtformation auf einmal erzeugt wird, wobei bei Laser-basierten Systemen der Laserstrahl die Geometrie der Schicht abfahren muss. Dabei erfolgt die Aushärtung des fotosensitiven Materials in einer Referenzschicht oder Referenzebene: dies kann die Oberfläche eines Bodens oder eine andere geeignete definierte Fläche sein, und sie kann je nach Anwendung fest, flexibel oder flüssig ausgebildet sein. Nach der Verfestigung einer Schicht muss diese von der Referenzschicht möglichst schonend durch eine relativ Bewegung zwischen der Referenzschicht und einer Trägerfläche, an der die erzeugte Schicht haften soll, getrennt werden. Nach der erfolgreichen Trennung der erzeugten Schicht wird neues zur Verfestigung geeignetes Material zwischen der Referenzschicht und der zuletzt gebildeten Schicht nachgeführt; dies kann beispielsweise durch eine einfache Hubbewegung der Trägerfläche sichergestellt werden. Danach kann das nachgeflossene fotosensitive Material abermals durch Bestrahlen ausgehärtet werden. Um das gewünschte dreidimensionale Objekt zu erzeugen, werden die beschriebenen einzelnen Verfahrensschritte so oft wiederholt, bis sämtliche zur Bildung des Körpers bzw. Objekts notwendigen Schichten erzeugt wurden.

Nachteilig an einem solchen Stereolithographie-Prozess sind die langen Prozesszeiten und Wartezeiten, die während des Trennens einer Schicht auftreten. Diese Zeiten machen einen Großteil der gesamten Prozesszeit aus. Weiters ist von Nachteil, dass Belichtungsfehler nicht erkannt werden können, und dass es zu keiner Anhaftung an der Trägerfläche kommen kann; auch ist die Einstellung der Startposition sowie der Nullposition der Anlage problematisch.

Aus dem Stand der Technik ist es bekannt, die Abzugskräfte in einem Stereolithographie-Prozess während des Trennens der erzeugten Schicht von der Referenzschicht an der Träger-Plattform integral zu messen. Ein Beispiel für ein derartiges Verfahren ist in EP 2 043 845 B1 beschrieben, wobei ein Kraftmess-Sensor an einer Bauplattform bzw. Träger-Plattform befestigt wird. Dieser Sensor ermöglicht das Messen der Abzugskräfte, die während des Lösens einer gerade gebildeten Bauteilschicht bzw. des Bauteils von einer Referenzschicht auftreten. Dadurch kann der Bauprozess beschleunigt werden. Der in der EP 2 043 845 B1 beschriebene Kraftsensor, welcher beispielweise als Dehnmesstreifen ausgeführt werden kann, misst in der beschriebenen Anordnung die Summe der Kräfte, welche an den generierten Schichten beim Ablösen erzeugt wird. Von Nachteil ist dabei, dass nur die Summe der Kräfte, die beim Trennen von mehrere Bauteilschichten auftreten, erfasst werden kann, nicht aber die Trennkraft eines bestimmten Bauteiles bzw. einer bestimmten Schicht. Auch kann nur die insgesamt auftretende Trennkraft als Funktion der Zeit erfasst werden. Es können zudem keine Aussagen und Rückschlüsse auf die Abhängigkeit der Kraft von der Schichtgeometrie eines einzelnen Körpers gemacht werden und somit auch keine Aussagen darüber, ob im Falle der gleichzeitigen Generierung von mehreren Körpern alle Körper auch verlässlich und komplett gebaut werden. Überdies lassen sich bei den bekannten Verfahren keine Rückschlüsse über den Polymerisationsprozess der Schicht oder des Körpers ziehen.

EP2178694A1 offenbart ein Verfahren zur Herstellung einer Linse aus einem reaktiven Gemisch auf einem Substrat mittels einer Quelle aktinischer Strahlung, die so gesteuert werden kann, dass ein definierbarer Teil eines Volumens des reaktiven Gemischs ausgehärtet wird

Ziel der Erfindung ist es somit, mit einer verbesserten Technik (Vorrichtung, Verfahren) die vorstehend genannten Nachteile zu beheben und ein einfaches, schnelles, störungsfreies, kontinuierliches, wirtschaftliches sowie sich selbst überprüfendes Erzeugen von dreidimensionalen Körpern zu ermöglichen.

Mehr im Einzelnen ist es Aufgabe der Erfindung, ein Verfahren wie eingangs angegeben vorzusehen, bei dem eine genaue Aussage über den Prozessstatus laufend möglich ist, und bei dem die Erzeugung von mehreren Körpern gleichzeitig in einem stereolitographischen Prozess ermöglicht wird, wobei jeweils auch der Status der einzelnen Prozesse bzw. erzeugten Körper/Schichten ermöglicht wird.

Dieses Ziel wurde durch das Mess-Verfahren nach Anspruch 1 erreicht.

In den nachfolgenden Ausführungformen in denen eine Mess-Strahlung in eine Referenzschicht eingekoppelt wird, fällt nicht in dem Umfang der beanspruchten Erfindung.

Mehr im Einzelnen soll eine Interaktion zwischen einer Referenzfläche/-schicht und der jeweils gebildeten Schichten erfasst werden können.

Gemäß der Erfindung zeichnet sich das vorliegende Verfahren zur Erzeugung eines dreidimensionalen Körpers vor allem dadurch aus, dass Mess-Strahlung in eine Referenzschicht eingekoppelt wird und durch die interne Reflexion zum überwiegenden Teil innerhalb der Referenzschicht bleibt, und dass die Mess-Strahlung durch einen Sensor ortssowie zeitaufgelöst erfasst wird. Mit dieser Vorgangsweise ist es möglich, praktisch punktuell bzw. bereichsweise den Schichterzeugungsprozess, somit das 3D-Druckverfahren bzw. dessen Fortschritt, laufend zu überwachen und zu erfassen und dabei insbesondere auch unnötige Wartezeiten zu vermeiden.

Von besonderem Vorteil ist es dabei, wenn durch Verformung der Referenzschicht die interne Reflexion gestört wird, wobei Mess-Strahlung aus der Referenzschicht austritt. Auf diese Weise ist eine besonders genaue Erfassung des Prozessfortschritts, insbesondere auch bereichsweise, möglich.

Um die Messung zu verbessern, ist es weiters günstig, wenn der Sensor die austretende Mess-Strahlung gleichzeitig in mehreren Messbereichen erfasst.

Für die Durchführung der Messung ist es auch vorteilhaft, wenn die Referenzschicht flexibel und zumindest teilweise für die Mess- Strahlung transparent ist. Zur Folge der flexiblen Ausbildung der Referenzschicht ergibt sich bei Einwirken von Kräften eine Verformung dieser Referenzschicht, wodurch die Mess-Strahlung im Hinblick auf eine genaue Messung beeinflusst wird.

Besonders vorteilhafte Ergebnisse können weiters erzielt werden, wenn die Referenzschicht aus Silikon besteht. Auch ist es für die Durchführung der Messung günstig, wenn innerhalb der Referenzschicht Totalreflexion auftritt.

Eine besonders vorteilhafte Ausführungsform des vorliegenden Verfahrens zeichnet sich schließlich dadurch aus, dass als Mess- Strahlung Infrarot-Strahlung verwendet wird. Wenn somit der Sensor zusätzlich dafür ausgelegt ist, die Wärmestrahlung, die während des Verfestigens einer Schicht von zumindest einem Körper auf der Referenzschicht auftritt, zu erfassen, kann die Aushärtung in vorteilhafter Weise kontrolliert werden.

Beim vorliegenden Verfahren bzw. der zugehörigen Stereolithographie-Vorrichtung können zumindest zwei Mess-Strahlungsquellen, d.h. passive Strahlungsquellen, und zumindest ein zugehöriger Mess-Sensor vorgesehen sein.

Erfindungsgemäß kann ferner durch die Erfassung der ausgekoppelten orts- und zeitabhängigen Mess-Strahlung aus der Referenzschicht, zumindest qualitativ auf das Vorhandensein einer Zwischenphase innerhalb der fotoreaktiven Substanz rückgeschlossen werden. Diese Zwischenphase, die zumindest teilweise durch zumindest einen Inhibitor (z.B. Sauerstoff), keine oder eine nur sehr geringe Reaktivität aufweist, bildet eine Art "inerten" Schmierfilm aus. Dadurch können die während des Prozesses normalerweise auftretenden Haftkräfte stark reduziert und/oder fast vollständig reduziert werden. Da die austretende Messstrahlung in Zusammenhang mit den Haftkräften steht, kann durch die erfindungsgemäße Methode auf das Vorhandensein einer Zwischenphase, orts- wie auch zeitaufgelöst, während des Prozesses rückgeschlossen werden.

Die Erfindung wird nachfolgend anhand von bevorzugten Ausführungsbeispielen und unter Bezugnahme auf die Zeichnung noch weiter erläutert. Im Einzelnen zeigen in der Zeichnung in schematischer Form:
- Fig. 1: eine schematische Ansicht eines Beispiels einer Stereolithographie-Anlage zur Veranschaulichung des vorliegenden Verfahrens;
- Fig. 2: eine Ansicht einer demgegenüber abgewandelten StereoIithographie-Anlage,·
- Fig. 3: eine Prinzip-Skizze einer Anordnung zwecks Veranschaulichung des Messens einer Streustrahlung;
- Fig. 3a: eine gegenüber Fig. 3 vereinfachte Anordnung;
- Fig. 4: eine weitere Ausführungsform mit veränderter Position der passiven (Mess-) Strahlungsquelle; Fig. 4a die in Fig. 4 dargestellte Ausführungsform, jedoch ohne gesonderten Boden;
- Fig. 5: schematisch ein Beispiel einer vom Sensor erfassten Strahlungsinformation;
- Fig. 6: schematisch einen Schnitt durch einen Teil einer Anlage, mit modifizierter Messanordnung;
- Fig. 7a: eine Prinzipskizze einer Messanordnung zur Bestimmung des Vorhandseins einer Zwischenphase, wobei beispielweise angenommen werden kann, dass die Kräfte sehr klein sind; und
- Fig. 7b: eine Prinzipskizze, in der die Zwischenphase die Höhe aufweist, wobei h < H ist und Messstrahlung ausgekoppelt wird.

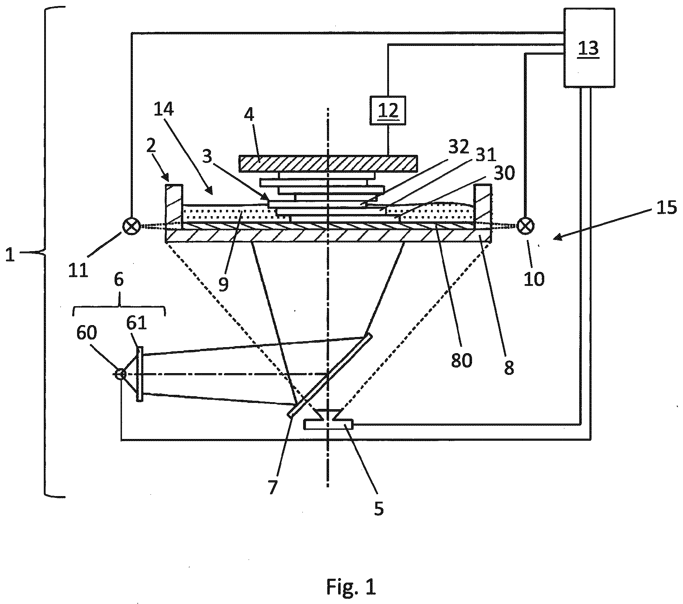

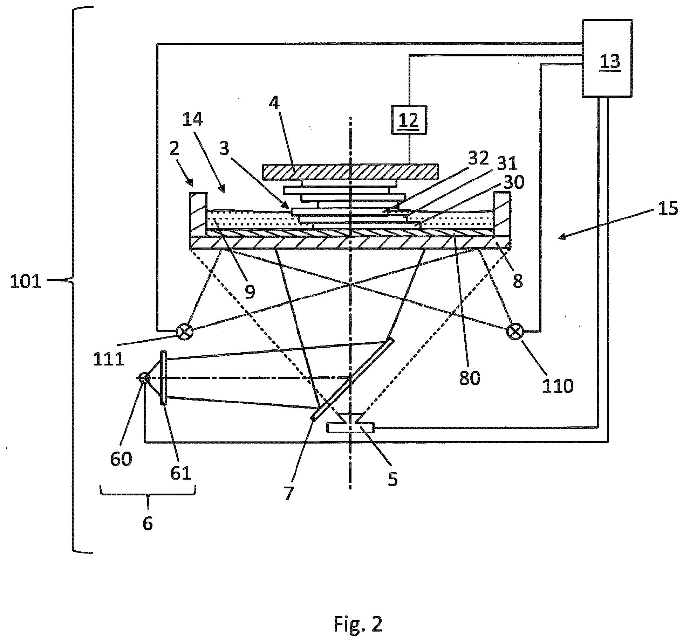

Fig. 1 zeigt beispielhaft ein Ausführungsbeispiel einer Stereolithographie-Anlage 1, teilweise im Schnitt, wobei diese Anlage 1 zur Herstellung eines oder mehrerer dreidimensionaler Körper 3 (s. auch Fig. 2 bis 4) aus einzelnen Schichten dient, die durch bereichsweises Verfestigen eines fotosensitiven Materials 9, welches sich in einer Wanne 2 befindet, die einen Aufnahmeraum 14 bildet, mittels einer aktinischen Strahlung ausgehärtet werden. Das fotosensitive Material 9, das sich im Aufnahmeraum 14 befindet, ist flüssig, wobei hier unter dem Begriff "flüssig" Flüssigkeiten mit beliebiger Viskosität, einschließlich Suspensionen und pastöse Substanzen, zu verstehen sind.

Eine oder mehrere passive Strahlungsquelle (n) 10, 11 ist/sind derart angeordnet, dass ein durch die Verformung einer Referenzschicht 80 entstehender Strahlungsunterschied von zumindest einem Sensor 5 erfasst werden kann. Gemäß Fig. 1 bilden ein Boden 8 und die Referenzschicht 80 einschließlich zugehöriger Wandungen eine Wanne 2, die als Aufnahmeraum 14 für das fotosensitive flüssige Material 9 dient. Unter "passive Strahlungsquelle" wird hier jene Strahlungsquelle verstanden, die als Messmittel dient, wobei ihre Strahlung entweder durch die Intensität und/oder durch die eingesetzte Wellenlänge nicht in der Lage ist, das fotosensitive Material 9 zu verfestigen. Eine steuerbare Strahlungsquelle, insbesondere Lichtquelle, 60 ist z.B. unterhalb der Wanne 2 angeordnet, wobei der emittierte Strahl der Lichtquelle 60 beispielweise durch einen Spiegel 7 umgelenkt wird. Der Spiegel 7 kann dabei so ausgeführt sein, dass er nur die Strahlung der Lichtquelle 60 reflektiert, für andere Wellenlängenbereiche jedoch durchlässig ist. Der Strahlungsquelle 60 ist gemäß Fig. 1 beispielsweise ein optisches Element 61, z.B. eine Linse, vorgeordnet, und die so gebildete Strahlungseinheit ist insgesamt mit 6 bezeichnet. Die Strahlungsquelle 60 kann z.B. herkömmliches Licht, aber auch IR- oder UV-Strahlung abgeben.

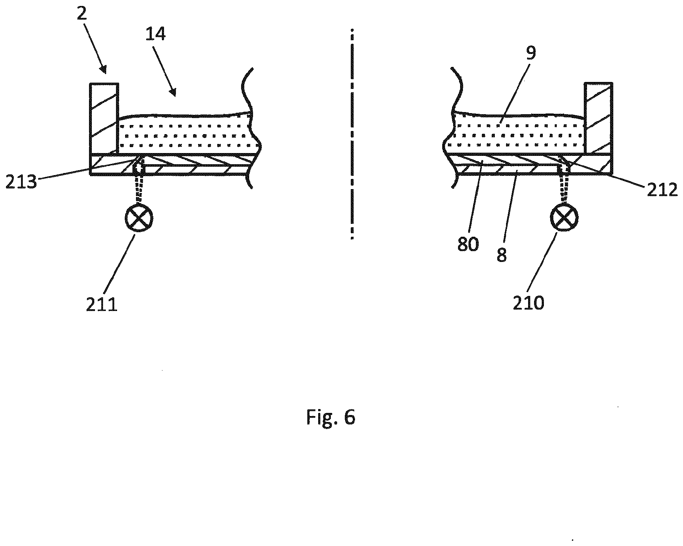

Eine Trägerfläche 4 kann durch einen Aktuator 12, beispielsweise einen Schrittmotorantrieb, gegenüber dem Aufnahmeraum 14 bewegt werden. Die Wanne 2 ist vorteilhafterweise so ausgeführt, dass sie zu der oder den passiven Lichtquelle (n) z.B. 10, 11, sowie zur Strahlungseinheit 6, beim Einlegen in die Stereolithographie-Anlage genau ausgerichtet und zentriert werden und eine bestimmte für die Messmethode vorteilhafte Position zu der oder den passiven Lichtquelle (n) 10, 11, welche sich im Anlagenraum 15 befinden, einnehmen kann. Vorteilhafterweise kann auch der Sensor 5 eine beliebige für die Messmethode sinnvolle Position innerhalb des Anlagenraumes 15 einnehmen. Die Wanne 2 selbst kann ebenfalls so gestaltet sein, dass sie in der Lage ist, den Strahlengang der passiven Lichtquellen 10 bzw. 11 umzulenken, vgl. auch Fig. 6, um so beispielsweise in einer bestimmten Ausführungsform eine platzsparende Anordnung der passiven Lichtquellen 10, 11 zu ermöglichen.

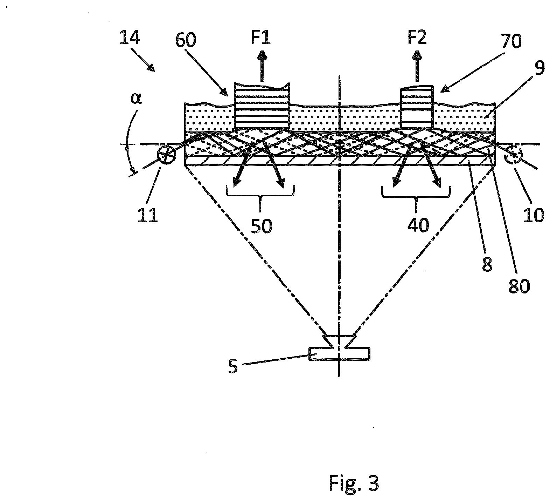

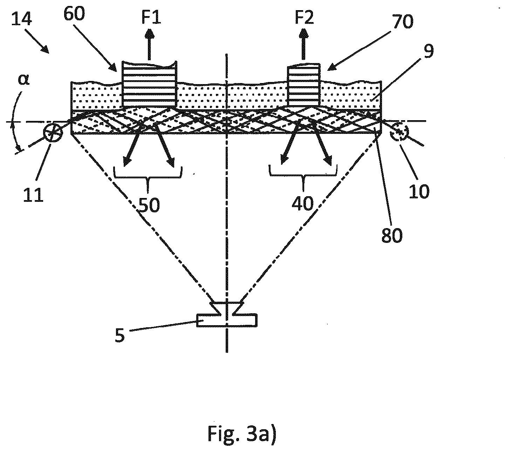

Gemäß Fig. 1 wird die passive Strahlung von der Seite in die Referenzschicht 80 eingekoppelt, um sich beispielweise durch interne Totalreflexion (vgl. Fig. 3) innerhalb der Referenzschicht 80 gleichmäßig auszubreiten. Eine Steuereinrichtung 13, beispielsweise ein Steuercomputer, steuert die Bewegungen der Trägerfläche 4 sowie die gesamten Prozessabläufe, die zur Herstellung des Körpers 3 in der Anlage 1 notwendig sind, einschließlich der Lichtquelle 60 bzw. 6 und erfasst über den zumindest einen Sensor 5 die passive Mess-Strahlung, um diese auszuwerten.

Fig. 2 zeigt im Vergleich zu Fig. 1 eine Ausführungsvariante einer Stereolithographie-Anlage 101, in welcher sich die passiven Strahlungsquellen 110, 111 unterhalb der Wanne 2 im Anlagenraum 15 befinden und die Unterseite der Wanne 2 bestrahlen sowie vorzugsweise gleichmäßig ausleuchten. Dabei befindet sich der zumindest eine Sensor 5 ebenfalls im Anlagenraum 15, und er erfasst die Reflexion bzw. die Streustrahlung von der Unterseite der Wanne 2, welche zumindest durch die Referenzfläche 80, gegebenenfalls auch durch einen Boden 8, gebildet wird. In dieser Ausführungsform wird die passive Strahlung nicht zwingenderweise in die Referenzschicht 80 bzw. die Wanne 2 eingekoppelt, und die Wanne 2 muss nicht voll transparent für die passive Strahlung sein, es muss lediglich ein gewisses Reflexionsvermögen der Referenzschicht 80 für die passive Strahlung gegeben sein.

Abweichend von den Ausführungsformen gemäß Fig. 1 und 2 kann die Anlage, z.B. 1, auch einen Sensor 5 aufweisen, welcher in der Lage ist, die durch die Strahlungsquelle 60 ausgelösten exothermen Verfestigungsprozesse zu erfassen. Dies gestattet die zumindest teilweise Erfassung des Polymerisationszustandes der gebildeten Schicht, z.B. 30, 31, 32, und es kann durch die Aufnahme der Strahlung durch den Sensor 5 auch ein Rückschluss auf den möglichen Trennvorgang der erzeugten Schicht, z.B. 30, 31, 32, gewonnen werden.

Fig. 3 zeigt einen Detail-Schnitt durch den Aufnahmeraum 14, in dem zwei Körper 60, 70 erzeugt werden. In dieser Fig. 3 sind zum besseren Verständnis die Referenzschicht 80 und die in diese eingekoppelte, durch innere Totalreflexion transportierte passive Strahlung der passiven Strahlungsquellen 10, 11 anhand von beispielhaften, zick- zack-förmigen geometrischen Strahlengängen schematisch dargestellt. Die Fig. 3 zeigt auch die durch Trennkräfte F1 und F2 an den Körpern 60 bzw. 61 erzeugte Verformung der elastischen Referenzschicht 80. Dabei dient der - optionale - Boden 8 lediglich als Unterstützung der elastischen Referenzfläche 80. Die Trennkräfte F1 und F2 sind in der gezeigten Darstellung nicht gleich, da der Körper 60 eine im wesentlichen größere Querschnittsfläche als der Körper 70 aufweist, und es gilt somit in diesem Beispiel F1 > F2, wobei in der Folge auch die Verformung der Referenzschicht 80 unterschiedlich ist.

Durch die unterschiedliche Verformung wird somit auch die Totalreflexion innerhalb der Referenzschicht 80 ortsabhängig gestört, und es werden demgemäß Strahlungen 40, 50 aus der Referenzschicht 80 in einem gewissen Verhältnis zur jeweilig auftretenden Trennkraft F1, F2 ausgekoppelt. Dabei kann die Position der passiven Lichtquellen 10, 1 zur optimalen Einstellung der Totalreflexion innerhalb der Referenzschicht 80 beispielsweise um einen Winkel α im Anlagenraum 15 positioniert werden, es versteht sich aber, dass die passiven Strahlungsquellen 10, 11 in allen Raumkoordinaten frei positioniert werden können. Der Sensor 5 erfasst dabei die Position sowie das zeitliche Verhalten (Intensitätsverlauf) der von der jeweiligen Kraft z.B. F1 bzw. F2, abhängigen Streustrahlung 40 bzw. 50.

Fig. 3a zeigt eine Ausführungsform der Anlage 1 ohne gesonderten Boden 8, und zwar ebenfalls in einem schematischen Schnitt. Dabei bildet die elastische Referenzschicht 80 gleichzeitig den Boden der Wanne 2. Dies bietet den Vorteil, dass die in dieser Fig. 3a dargestellten Streustrahlungen 40, 50 nicht durch eine weitere Schicht abgeschwächt werden. Zusätzlich kann die Referenzschicht 80 in ihrer Elastizität und Dicke so ausgeführt werden, dass sich eine gewünschte Tragfähigkeit der Wanne 2 (in Fig. 1 und 2) für die fotosensitive Flüssigkeit 9 ergibt, und zwar bei einem gleichzeitigem "membranartigen" Verhalten der Referenzschicht 80, welches die Trennung der Körper 60, 70 begünstigt und die Trennkräfte Fl, F2 minimiert. Auch kann beispielsweise durch eine dickere Referenzschicht 80 einfacher passive Strahlung in diese Referenzschicht 80 eingekoppelt werden, und die Position der Wanne 2 bzw. der passiven Strahlungsquellen 10, 11 im Anlagenraum 15 (s. Fig. 2) muss weniger exakt eingestellt werden.

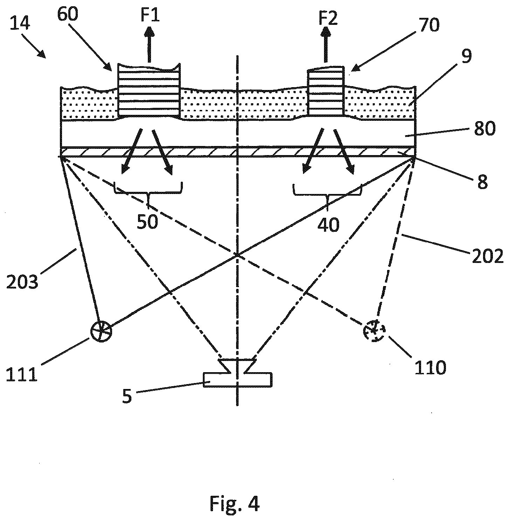

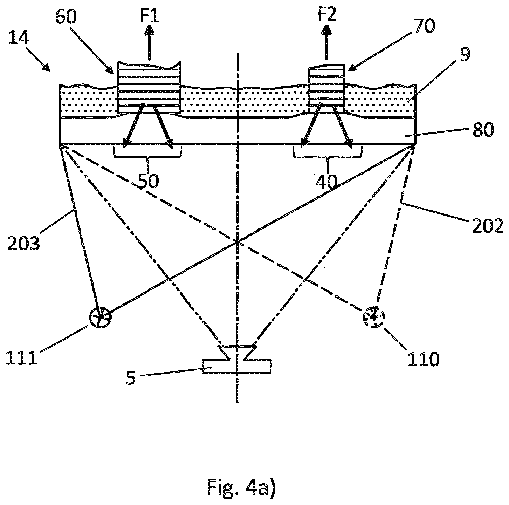

Fig. 4 illustriert ebenfalls einen Schnitt durch den Aufnahmeraum 14 einer Anlage, in der die passiven Strahlungsquellen 110, 111 unterhalb der Wanne 2 in einer Position im Anlagenraum 15 angeordnet sind und zumindest die Referenzschicht 80 sowie den optionalen Boden 8 mehr oder weniger gleichmäßig ausleuchten. Durch die von der Querschnittsfläche des oder der gebildeten Körper (s) 60 bzw. 70 abhängigen Trennkräfte F1, F2 wird zumindest wie gezeigt die elastische Referenzschicht 80 verformt. In der Darstellung ist beispielsweise wiederum illustriert, dass der Körper 60 eine größere Querschnittsfläche als der Körper 70 aufweist und somit angenommen werden kann, dass die Trennkraft F1 größer als die Trennkraft F2 ist. Durch die Trennkräfte F1, F2 wird die elastische Referenzschicht 80 wiederum ortsabhängig verformt und es ergibt sich entsprechend der Größe der Verformung zumindest der Referenzschicht 80 eine Änderung der Ausleuchtung durch die passiven Strahlungsquellen 110, 111. Durch die Verformung wird ein anderes zeitliches und ortsabhängiges Reflexionsverhalten der Wanne 2 bzw. der Referenzschicht 80 und/oder des Bodens 8 bewirkt, welches wiederum durch den Sensor 5 erfasst werden kann.

Fig. 4a zeigt eine Ausführungsvariante, ausgehend von der Anlage gemäß Fig. 4, wobei wiederum der Boden 8 weggelassen wurde, ähnlich wie im Fall der Fig. 3a im Verhältnis zur Fig. 3. Auch hier ist wieder davon auszugehen, dass die Referenzschicht 80 ausreichend stabil ist, um die Flüssigkeit 9 und die geformten Körper 60, 70 zu tragen. Im Weiteren sind ähnlich wie in Fig. 4 die Strahlen der Strahlungsquellen 110 und 111 bei 202 und 203 schematisch veranschaulicht. Schließlich ist auch wiederum die jeweilige Strahlung 50 bzw. 40 veranschaulicht.

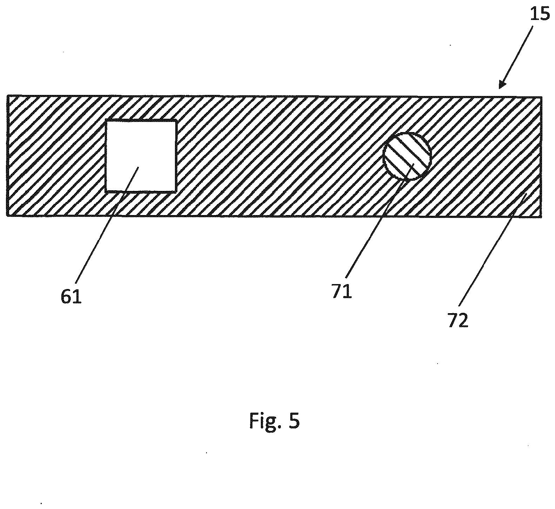

Fig. 5 illustriert beispielhaft eine vom Sensor 5 erfasste, z.B. durch Einwirkung der Kräfte F1, F2 und der dadurch resultierenden zeit- und ortsabhängige Verformung der Referenzfläche 80 und gegebenenfalls auch des Bodens 8 der Wanne 2, verursachte orts- und zeitabhängige Änderung der Intensitätsverteilung der passiven Strahlung durch eine ausgekoppelten Strahlung (s. Fig. 3, Fig. 3a) oder durch eine Änderung der Reflexion (s. Fig. 4 und Fig. 4a) im vom zumindest einen Sensor 5 erfassten Messraum 15. Dabei treten beispielsweise im vom Sensor 5 erfassten Bereich, abhängig von der auftretenden Verformung der elastischen Referenzschicht 80, Bereiche 61, 71 auf, die jeweils von der vom jeweiligen Körper 60, 70 unterschiedlichen Intensitätsverteilung abhängen; diese Intensivitätsverteilungen werden orts- und zeitabhängig vom Sensor 5 erfasst und stehen in einem Bezug zu den auftretenden Trennkräften F1, F2. Ist beispielsweise der Sensor 5 als Infrarot-Kamera ausgeführt, und wird als passive Strahlung Infrarot Strahlung eingesetzt, so erfasst der Sensor 5 einen bestimmten Messbereich des Messraumes 15 als Bildinformation oder Videoinformation welche die geometrische Ausprägung der Querschnittsflächen, eine Intensitätsverteilung entsprechend der auftretenden Trennkräfte F1, F2, entweder in vorgegebenen zeitaufgelösten Schritten oder kontinuierlich darstellt. Dabei wird beispielsweise in Bereichen 72 in denen keine oder weniger Verformung auftritt, weniger passive Strahlung vom Sensor 5 erfasst, und diese erscheinen somit Beispiel weise in dem vom Sensor 5 erfassten Gesamtbild dünkler als z.B. die Bereiche 61, 71, in denen eine Verformung der elastischen Referenzschicht 80 auftritt.

Es versteht sich von selbst, dass der Fachmann ohne Weiters aus den hier offenbarten Ausführungsformen der Erfindung diverse Abwandlungen und Ergänzungen vornehmen kann.

In Fig. 6 ist schematisch, mit teilweise veranschaulichter Wanne 2, eine Ausführungsform gezeigt, bei der unterhalb der Wanne 2 vorgesehene Strahlungsquellen 210, 211 Strahlung nach oben in den Boden 8 der Wanne 2 einkoppeln, der wiederum durch die Referenzschicht 80 gebildet ist. In dieser Referenzschicht 80 sind im Strahlengang der Strahlungsquellen 210, 211 schräg angeordnete Spiegel oder Lichtleiterelemente 212 bzw. 213, welche vorzugsweise direkt aus dem Material der Referenzfläche gebildet sind, angebracht bzw. gebildet, um die von den Strahlungsquellen 207, 211 abgegebene Mess-Strahlung umzulenken und dabei in den Boden 8 bzw. die Referenzschicht 80 einzukoppeln. Auch wenn das nicht näher in Fig. 6 veranschaulicht ist, kann dabei diese Einkopplung wiederum, ähnlich wie gemäß Fig. 3, mit einem Winkel erfolgen, so dass sich eine Totalreflexion der Referenzschicht 80 ergibt (in Fig. 6 nicht dargestellt).

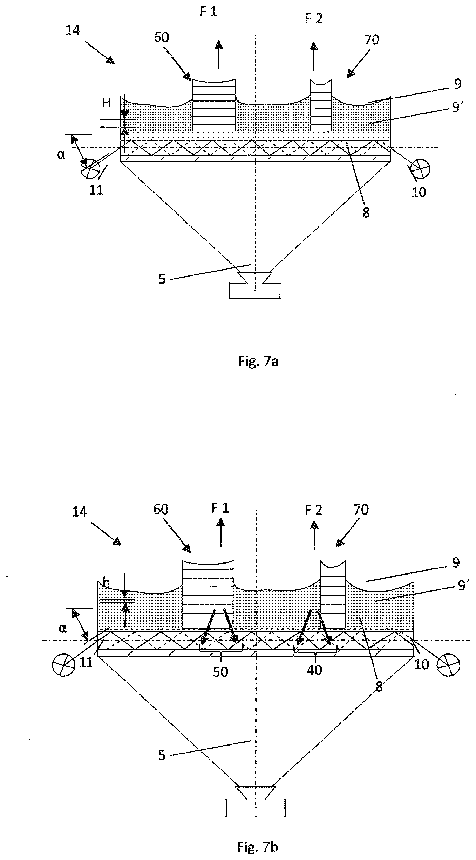

Im Übrigen kann wiederum ein unterseitiger Sensor 5, wie in den Fig. 1 bis 5 gezeigt, vorgesehen sein, und ebenso kann eine Steuereinrichtung 13, wie in Fig. 1 und 2 gezeigt, angebracht sein. Fig. 7a zeigt einen Detail-Schnitt durch einen Aufnahmeraum 14, in dem zwei Körper 60, 70 erzeugt werden. Das fotosensitive Material 9 weist wie in Fig. 7a gezeigt eine Zwischenphase 9A auf. Diese Zwischenphase 9A weist eine gegenüber dem Material 9 reduzierte Reaktivität auf. Dieser Reaktivitätsunterschied, der zur Ausbildung der Zwischenphase 9A im fotoreaktiven Material 9 führt, kann beispielweise durch chemische Inhibitoren, wie beispielsweise Sauerstoff erzielt werden. Die Dicke H der Zwischenschicht 9A hat dabei, wie in Fig. 7a dargestellt, einen solchen Wert (wie zum Beispiel 30, 50, 100 Mikrometer etc.), so dass die Zwischenschicht 9A die Ausbildung der Trennkräfte F1, F2 zumindest weitmöglichst verhindert, wenn nicht vollkommen unterdrückt/verhindert. Durch das Fehlen der Trennkräfte kommt es im Idealfall zu keiner Auskoppelung von Messstrahlung. Somit kann ein Rückschluss auf das Vorhandensein einer ausreichenden Zwischenschicht gewonnen werden.

Fig. 7b zeigt wie Fig. 7a einen Detail-Schnitt durch den Aufnahmeraum 14, wobei in dieser Prinzipskizze ein Fall dargestellt ist, in dem die Zwischenschicht 9A eine Dicke h aufweist. Dabei gilt h ist kleiner H (h<H). In der dargestellten Prinzipskizze ist beispielhaft also ein möglicher Grenzfall dargestellt in der die Zwischenschicht 9A auf einen Grenzwert h abgefallen ist, beispielsweise durch Konsum des Inhibitors oder durch Prozessgrößen, so dass erstmals messbare Trennkräfte F1 und F2 auftreten. Dadurch kann im Rückschluss - und dies ggf. orts- und zeitaufgelöst - festgestellt werden, wo der Grenzfall der Zwischenschichtdicke erreicht wurde, um ggf. prozesstechnische Schritte auszulösen um die Zwischenschicht 9A entsprechend zu regenerieren und/oder aktiv nachzubilden. Beispielsweise kann dies durch zusätzliche und/oder gesteigerte Zufuhr zumindest eines Inhibitors erfolgen, durch Änderung einer Inhibitorkonzentration (beispielsweise Sauerstoff-angereicherter Luft), durch entsprechende Variation der Prozessgrößen wie der Belichtungsenergie, Wartezeiten, Hubgeschwindigkeit etc., und/oder durch gezieltes Einführen von Pausen.

Diese Änderungen tragen im Einzeln oder in Kombination zur Steigerung der Höhenausdehnung der Zwischenschicht 9' bei. Mit der beschriebenen Messmethode können auch ortsaufgelöst und zeitaufgelöst Änderungen der Zwischenschicht 9A erfasst werden, durch eine beispielsweise gezielte ortsaufgelöste Zufuhr von Inhibitor, welche nur in dem Bereich erfolgt, wo die Zwischenschicht gezielt erhöht oder regeneriert werden soll. Dies gezielte Zuführung könnte auch in Abhängigkeit von der geometrischen Ausdehnung des Körpers erfolgen bzw. je nach Belichtungsfläche. So kann durch das beschriebene Messverfahren abhängig von der Ausdehnung des zu generierenden Körpers die Dicke der Zwischenschicht 9A gezielt ggf. lokal erfasst und erhöht werden.

## Patentansprüche

1. Messverfahren während der Erzeugung eines dreidimensionalen Körpers (60, 70) in einem stereolithographischen Prozess, wobei ein fotosensitives Material (9) durch Strahlung aus einer Strahlungsquelle (60) ausgehärtet wird, **dadurch gekennzeichnet, dass**
die durch die Strahlungsquelle (60) ausgelösten exothermen Verfestigungsprozess durch einen Sensor (5) erfasst werden um zumindest teilweise den Polymerisationszustand der gebildeten Schicht (30, 31, 32) zu erfassen und durch die Aufnahme der Strahlung durch den Sensor (5) auch ein Rückschluss auf den Trennvorgang der erzeugten Schicht (30, 31, 32) zugewinnen, wobei der Sensor (5) als eine Infrarot-Kamera ausgeführt wird.

## Claims

1. Measurement method during the production of a three-dimensional body (60, 70) in a stereolithographic process, wherein a photosensitive material (9) is cured by radiation from a radiation source (60), **characterized in that**
the exothermic solidification processes triggered by the radiation source (60) are detected by a sensor (5) in order to at least partially detect the polymerization state of the layer (30, 31, 32) formed and the detection of radiation by the sensor (5) also enables conclusions to be drawn about the separation process of the produced layer (30, 31, 32), wherein the sensor (5) is designed as an infrared camera.

## Revendications

1. Procédé de mesure pendant la fabrication d'un corps tridimensionnel (60, 70) dans un processus stéréolithographique, dans lequel un matériau photosensible (9) est durci par rayonnement à partir d'une source de rayonnement (60), **caractérisé en ce que**
les processus de solidification exothermiques déclenchés par la source de rayonnement (60) sont détectés par un capteur (5) afin de détecter au moins partiellement l'état de polymérisation de la couche formée (30, 31, 32) et, grâce à l'enregistrement du rayonnement par le capteur (5), de parvenir également à une conclusion sur le processus de séparation de la couche produite (30, 31, 32), ledit capteur (5) étant conçu comme une caméra infrarouge.
